# EUROPEAN PATENT APPLICATION

(11) **EP 1 903 600 A2**
(43) Date of publication of application: **26.03.2008**
(21) Application number: 07017796.9
(22) Date of filing: 11.09.2007
(51) Int. Cl.: H01L 21/223, H01L 21/285, H01L 21/225

(54) **Method for producing P-type group III nitride semiconductor and method for producing electrode for P-type group III nitride semiconductor**

(30) Priority: 20.09.2006 JP 2006254965
(71) Applicant: Toyota Jidosha Kabushiki Kaisha, Aichi-ken, 471-8571 (JP)
(72) Inventor: Sugimoto, Masahiro, Toyota-shi Aichi-ken, 471-8571 (JP); Kanechikia, Masakazu, Nagakute-cho Aichi-gun Aichi-ken, 480-1192 (JP); Kikuta, Daigo, Nagakute-cho Aichi-gun Aichi-ken, 480-1192 (JP); Ishiguro, Osamu, Nagakute-cho Aichi-gun Aichi-ken, 480-1192 (JP); Uesugi, Tsutomu, Nagakute-cho Aichi-gun Aichi-ken, 480-1192 (JP); Kachi, Tetsu, Nagakute-cho Aichi-gun Aichi-ken, 480-1192 (JP)
(74) Representative: Winter, Brandl, Fürniss, Hübner Röss, Kaiser, Polte Partnerschaft Patent- und Rechtsanwaltskanzlei

(57) **Abstract**

The present invention provides a p-type group III nitride semiconductor production method which is excellent in terms of reliability and reproducibility. A photoresist mask is formed on a surface of an n⁻-GaN layer. Subsequently, an Mg film is formed so as to cover the n⁻-GaN layer and the photoresist mask, and an Ni/Pt metal film is formed on the Mg film. Thereafter, the photoresist mask is removed, whereby the Mg film and the metal film remain only on a portion of the n⁻-GaN layer where a p-type region is formed. Subsequently, when thermal treatment is performed in an ammonia atmosphere at 900°C for three hours, Mg is diffused in the n⁻-GaN layer while being activated. Therefore, a p-type region is formed. Thereafter, the Mg film and the metal film are removed by use of aqua regia.

## Description

### BACKGROUND OF THE INVENTION

### Field of the Invention

The present invention relates to a method for selectively producing a p-type group III nitride semiconductor; and to a method for producing an electrode for a p-type group III nitride semiconductor. These methods realize excellent reliability and reproducibility.

### Background Art

In recent years, group III nitride semiconductors have been envisaged not only as materials for forming light-emitting elements, but also as semiconductors for forming next-generation power devices. This is because the breakdown electric field of a group III nitride semiconductor is one order of magnitude larger than that of silicon.

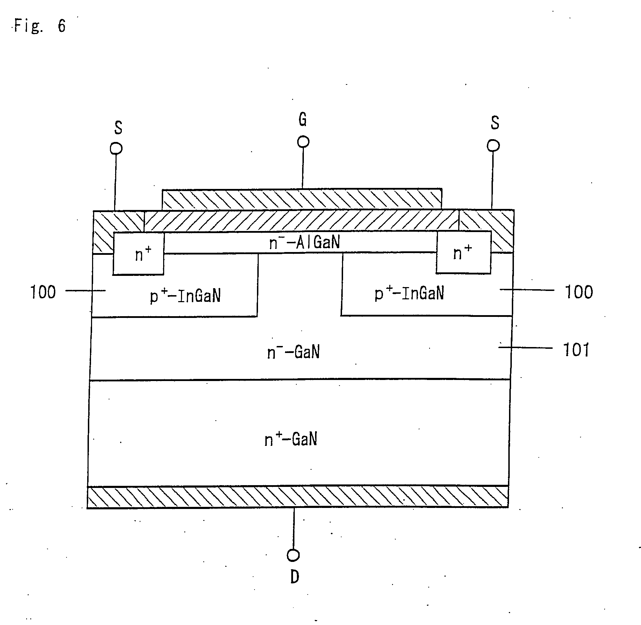

For realization of power devices with high breakdown voltage, generally, a vertical structure is more advantageous than a lateral structure, from the viewpoints of voltage resistance and high-current operation. Japanese Patent Application Laid-Open (kokai) No. 2004-260140 discloses several semiconductor devices, each having a vertical structure and employing a group III nitride semiconductor. FIG. 6 is a cross-sectional view showing the structure of one of the disclosed semiconductor devices. A p⁺-InGaN layer 100 is isolated to left and right portions by an n⁻-GaN layer 101 provided therebetween. Realization of this structure requires a technique for selectively forming a p-type group III nitride semiconductor.

Japanese Patent Application Laid-Open (kokai) No. 2004-260140 and The 53rd Meeting of Japan Society of Applied Physics and Related Societies (proceedings 24a-ZE-15 and 24a-ZE-16) disclose a method for selectively producing a p-type group III nitride semiconductor by a dry etching technique.

In the production method disclosed in Japanese Patent Application Laid-Open (kokai) No. 2004-260140, firstly, an SiO₂ mask is formed on an n-type GaN layer, except for a portion of the layer on which p-type GaN is grown, and the n-type GaN layer is dry-etched until the depth of the etched portion reaches a predetermined level. Subsequently, p-type GaN is selectively grown on the dry-etched portion by MOCVD, followed by removal of the SiO₂ mask.

In the production method disclosed in The 53rd Meeting of Japan Society of Applied Physics and Related Societies (proceedings 24a-ZE-15 and 24a-ZE-16), firstly, p-type GaN is epitaxially grown by MOCVD. Secondly, a region of the p-type GaN is dry-etched by use of an SiO₂ mask. Thirdly, the SiO₂ mask is removed, and, subsequently, n-type GaN is grown on the dry-etched region. Alternatively, without removal of the SiO₂ mask, n-type GaN is selectively grown on the dry-etched region.

Other techniques for selectively forming a p-type group III nitride semiconductor include a production method employing ion implantation (e.g., Japanese Patent Application Laid-Open (kokai) No. 2005-183668); and methods disclosed in Japanese Patent Application Laid-Open (kokai) No. H11-224859 and Y. J. Yang, J. L. Yen, F. S. Yang, and C. Y. Lin: Jpn. J. Appl. Phys. 39 (2000) L390-L392.

In the production method disclosed in Japanese Patent Application Laid-Open (kokai) No. 2005-183668, Mg ions are implanted into a group III nitride semiconductor by use of an Mg ion beam, followed by thermal treatment in an atmosphere of an ammonia-hydrogen gas mixture, to thereby form a p-type group III nitride semiconductor.

In the methods disclosed in Japanese Patent Application Laid-Open (kokai) No. H11-224859 and in Y. J. Yang, J. L. Yen, F. S. Yang, and C. Y. Lin: Jpn. J. Appl. Phys. 39 (2000) L390-L392, an Mg film is formed on a group III nitride semiconductor layer, followed by thermal treatment, to thereby diffuse Mg in the group III nitride semiconductor layer. These methods differ from each other in that, in the former method, Mg is diffused through thermal treatment in a nitrogen atmosphere, whereas in the latter method, Mg is diffused through thermal treatment in vacuum.

However, the production method disclosed in Japanese Patent Application Laid-Open (kokai) No. 2004-260140 or in The 53rd Meeting of Japan Society of Applied Physics and Related Societies (proceedings 24a-ZE-15 and 24a-ZE-16) poses a problem in that the method requires a complicated process; i.e., the method requires a subsequent growth step or a selective growth step, resulting in high production cost. In addition, during regrowth of n-type GaN, p-type GaN migrates on the growth surface through mass transportation, and p-type GaN is grown on the etched region (i.e., the region on which n-type GaN is subsequently grown).

The production method disclosed in Japanese Patent Application Laid-Open (kokai) No. 2005-183668, which employs ion implantation, poses problems (e.g., damage to a group III nitride semiconductor layer), and thus has not yet been established as a practical technique. Meanwhile, the production method disclosed in Japanese Patent Application Laid-Open (kokai) No. H11-224859 or Y. J. Yang, J. L. Yen, F. S. Yang, and C. Y. Lin: Jpn. J. Appl. Phys. 39 (2000) L390-L392 exhibits poor reliability and reproducibility. The production methods disclosed in Japanese Patent Application Laid-Open (kokai) No. 2005-183668 and Y. J. Yang, J. L. Yen, F. S. Yang, and C. Y. Lin: Jpn. J. Appl. Phys. 39 (2000) L390-L392 require additional thermal treatment for Mg activation.

### SUMMARY OF THE INVENTION

In view of the foregoing, an object of the present invention is to provide a novel method for producing a p-type group III nitride semiconductor, which method can be carried out in a small numbers of steps and realizes excellent reliability and reproducibility. Another object of the present invention is to provide a method for forming an electrode which comes into contact with a p-type group III nitride semiconductor, the method being an application of the production method.

In a first aspect of the present invention, there is provided a method for producing a p-type group III nitride semiconductor, the method comprising thermally diffusing Mg in a group III nitride semiconductor layer in an atmosphere containing at least ammonia, to thereby activate Mg and to form a p-type group III nitride semiconductor layer.

In a second aspect of the present invention, there is provided a method for producing a p-type group III nitride semiconductor, the method comprising forming an Mg film in a predetermined region on a surface of a group III nitride semiconductor layer; forming, on the Mg film, a film of a metal having a melting point higher than the temperature of a thermal treatment which follows; performing the thermal treatment in an atmosphere containing at least ammonia.

In the second aspect after performing the thermal treatment in an atmosphere containing at least ammonia, the Mg film and the metal film may be removed.

The present inventors previously conducted studies on the aforementioned conventional production methods (i.e., the method in which Mg is thermally diffused in vacuum or in a nitrogen atmosphere, and the method including ion implantation of Mg and subsequent thermal treatment). However, through these method, a p-type semiconductor did not produced. Therefore, reliability and reproducibility of these conventional production methods are to be further improved.

Under such circumstances, the present inventors have conducted extensive experiments in pursuit of a novel p-type semiconductor production method, and as a result have found that when a group III nitride semiconductor is heated in an atmosphere containing at least ammonia, so as to thermally diffuse Mg in the semiconductor, the semiconductor can be transformed into a p-type group III nitride semiconductor. The present invention has been accomplished on the basis of this finding.

One conceivable reason why a group III nitride semiconductor is transformed into a p-type group III nitride semiconductor through the aforementioned procedure is that when a group III nitride semiconductor is heated in an ammonia atmosphere, Ga and N constituting the semiconductor tend to migrate, and Mg properly enters Ga sites without affecting the crystal structure.

As used herein, "atmosphere containing at least ammonia" refers to an atmosphere containing ammonia singly, or an atmosphere of a gas mixture of ammonia with hydrogen or an inert gas (e.g., nitrogen, argon, or helium). When the atmosphere containing at least ammonia is such a gas mixture atmosphere, no particular limitation is imposed on the ammonia concentration, so long as a group III nitride semiconductor can be transformed into a p-type group III nitride semiconductor.

In the aforementioned aspects of the present invention, the entirety of a group III nitride semiconductor can be transformed into a p-type group III nitride semiconductor, or a predetermined region (e.g., merely an islands-pattern region) of a group III nitride semiconductor can be transformed into a p-type group III nitride semiconductor.

As used herein, "group III nitride semiconductor" is a semiconductor represented by the formula AlₓGa_{y}In_{1-x-y}N (0 ≤ x ≤1, 0 ≤ y ≤ 1, 0 ≤ 1-x-y ≤ 1), such as GaN or AlGaN. Such a group III nitride semiconductor may have any conduction type. When a p-type group III nitride semiconductor layer is employed, a p-type region having a hole concentration higher than that of the group III nitride semiconductor layer is formed under Mg film. In a third aspect of the present invention, an intrinsic or n-type group III nitride semiconductor layer is employed. In such a case, a p-type region is formed in the group III nitride semiconductor layer under Mg film.

In the first and second aspects of the present invention, through thermal treatment in an atmosphere containing at least ammonia, Mg can be diffused in a group III nitride semiconductor layer while Mg contained in the group III nitride semiconductor layer can be activated. In this case, in addition to Mg, a metal constituting a metal film inevitably diffuses in the group III nitride semiconductor layer. However, the metal does not impede formation of a p-type group III nitride semiconductor. The film of a metal having a melting point higher than the temperature for thermal treatment is formed on the Mg film in order to prevent vaporization of Mg due to heating.

No particular limitation is imposed on the temperature for thermal treatment, so long as Mg is thermally diffused in a group III nitride semiconductor. The thermal treatment temperature is, for example, 700°C to 1,150°C. When thermal treatment is performed at a temperature higher than 1,150°C, the amount of Mg which thermally diffuses increases, but numerous point defects are generated in the group III nitride semiconductor. Alternatively, the surface of the group III nitride semiconductor is etched by Mg, resulting in considerable surface roughening. Therefore, thermal diffusion of Mg is not appropriate at such a high temperature.

In a fourth aspect of the present invention, after removal of the Mg film and the metal film, a thermal treatment may be further performed in an atmosphere predominantly containing nitrogen. Through this thermal treatment, Mg contained in the group III nitride semiconductor layer can be further activated.

In a fifth aspect of the present invention, formation of the Mg film, and formation of the metal film on the Mg film in a predetermined region may be performed through the lift-off process. Specifically, a photoresist mask is formed through photolithography on a group III nitride semiconductor layer, except for a predetermined region; an Mg film is formed through vapor deposition so as to cover the group III nitride semiconductor layer and the photoresist mask; a metal film is formed on the Mg film through vapor deposition; and subsequently the photoresist mask is removed, to thereby provide the Mg film and the metal film in the predetermined region.

The metal film may be made of, for example, Ni, Pt, or Au. The metal film may be formed of a plurality of layers. For example, the metal film may be an Ni/Pt film formed of an Ni lower layer and a Pt upper layer. The Mg film and the metal film may be removed by use of, for example, aqua regia.

In the first aspect of the present invention, a thermal treatment for the diffusion of Mg is performed in an atmosphere containing at least ammonia. However, the thermal treatment for Mg diffusion may be performed by use of a gas other than ammonia (e.g., nitrogen), followed by a thermal treatment in an atmosphere containing at least ammonia.

In a sixth aspect of the present invention, there is provided a method for producing an electrode for a p-type group III nitride semiconductor, the method comprising forming an Mg film in a predetermined region on a surface of a group III nitride semiconductor layer; forming an electrode film on the Mg film; and performing a thermal treatment in an atmosphere containing at least ammonia. In a seventh aspect of the present invention, after the thermal treatment in an atmosphere containing at least ammonia, a thermal treatment may be further performed in an atmosphere predominantly containing nitrogen. Through this thermal treatment, Mg contained in the group III nitride semiconductor layer can be further activated.

As described above, through thermal treatment in an ammonia atmosphere, Mg can be diffused while being activated. Therefore, a region having a hole concentration higher than that of the group III nitride semiconductor layer is formed in the layer below the Mg film. In case that the group III nitride semiconductor layer below the Mg film is p-type semiconductor, a region having a hole concentration higher than that of the p-type group III nitride semiconductor layer is formed in the layer below the Mg film. Since the Mg film and the electrode film come into contact with the region of high hole concentration, contact resistance can be reduced.

As described above, the Mg film and the electrode film may be formed in a predetermined region through the lift-off process. The electrode film may be made of, for example, Ni.

After the thermal treatment in an ammonia atmosphere, the Mg film and the electrode film may be removed, and an electrode film may be formed in the same region. Through this procedure, more favorable contact can be attained.

And also after the removal of the Mg film and the electrode film, a thermal treatment may be further performed in an atmosphere predominantly containing nitrogen and thereafter a new electrode film may be formed in the same region. And moreover a thermal treatment may be performed in order to alloy the new electrode with the p-type group III nitride semiconductor layer at the temperature lower than that of the thermal treatment. Contact resistance can be more reduced by this method.

Alternatively after the thermal treatment in an ammonia atmosphere and the removal of the Mg film and the electrode film, a new electrode film may be formed in the same region and a thermal treatment may be further performed in an atmosphere predominantly containing nitrogen. Contact resistance can be reduced by this method.

According to the first and second aspects of the present invention, since the thermal treatment for diffusing Mg in a group III nitride semiconductor layer is performed by use of a gas containing at least ammonia, a p-type group III nitride semiconductor can be formed in a highly reliable manner. In addition, since Mg can be diffused while being activated, diffusion and activation of Mg, which have conventionally been performed in two steps, can be carried out in a single step, resulting in simplification and high efficiency of a production process. The p-type group III nitride semiconductor production method according to the first or second aspect of the present invention is particularly effective for selectively producing a p-type group III nitride semiconductor, and attains excellent reliability and reproducibility. Therefore, the production method can easily realize a vertical group III nitride semiconductor device in which a p-type group III nitride semiconductor is required to be selectively produced. The production method does not require an additional growth step or a selective growth step--which step is required in the method for selectively producing a p-type group III nitride semiconductor disclosed in Japanese Patent Application Laid-Open (kokai) No. 2004-260140 or The 53rd Meeting of Japan Society of Applied Physics and Related Societies (proceedings 24a-ZE-15 and 24a-ZE-16)-and thus can reduce production cost.

According to the electrode production method of the sixth aspect of the present invention, since an Mg film comes into contact with a region having a high hole concentration, an electrode for a p-type group III nitride semiconductor exhibiting low contact resistance can be produced.

### BRIEF DESCRIPTION OF THE DRAWINGS

Various other objects, features, and many of the attendant advantages of the present invention will be readily appreciated as the same becomes better understood with reference to the following detailed description of the preferred embodiments when considered in connection with the accompanying drawings, in which:
FIGs. 1A to 1E show steps of a p-GaN production method according to Embodiment 1;
FIG. 2 is a graph showing temperature dependence of hole concentration;
FIG. 3 is a graph showing temperature dependence of hole mobility;
FIG. 4 is a graph showing the relation between depth as measured from a surface and Mg concentration;
FIGs. 5A and 5B show steps of an electrode production method according to Embodiment 2; and
FIG. 6 is a cross-sectional view showing a vertical semiconductor device employing a group III nitride semiconductor.

### DETAILED DESCRIPTION OF PREFERRED EMBODIMENTS

Specific embodiments of the present invention will next be described with reference to the drawings. However, the present invention is not limited to the embodiments.

### Embodiment 1

FIGs. 1A to 1E show steps of a p-GaN production method according to Embodiment 1. The production steps according to Embodiment 1 will next be described with reference to FIGS. 1A to 1E.

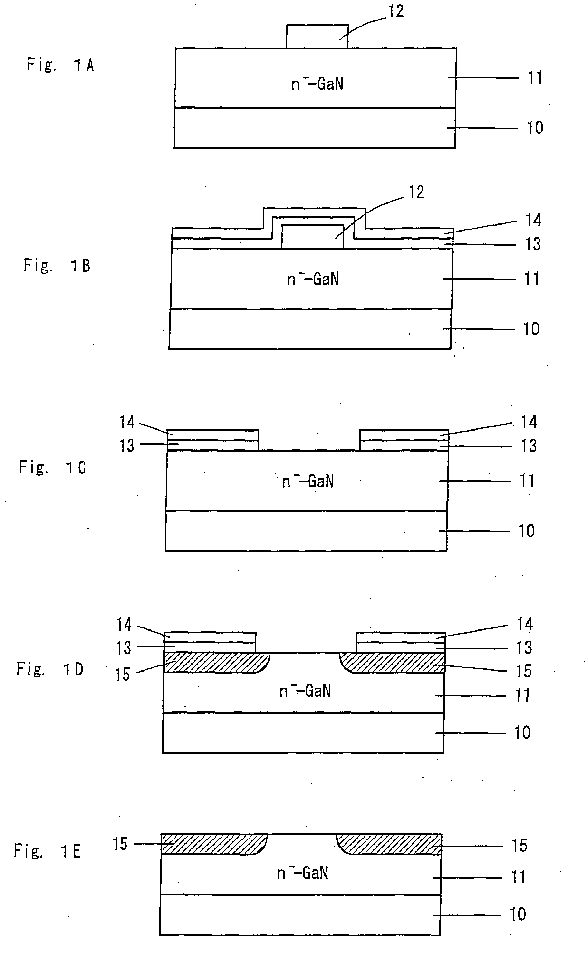

Firstly, an n⁻-GaN layer 11 (corresponding to a group III nitride semiconductor layer employed in the present invention), which is a low-concentration n-type layer, is formed on a sapphire substrate 10 by MOCVD. The n⁻-GaN layer 11 has a thickness of 1.65 µm. Subsequently, a photoresist mask 12 is formed on a surface of the n⁻-GaN layer 11 so that the mask 12 is provided on a portion of the n⁻-GaN layer 11 where a p-type region is not formed (FIG. 1A). Subsequently, an Mg film 13 is formed by vapor deposition so as to cover the n⁻-GaN layer 11 and the photoresist mask 12, and an Ni/Pt metal film 14 is formed on the Mg film 13 through vapor deposition (FIG. 1B). The Mg film 13 has a thickness of 50 nm, and the metal film 14 is formed of an Ni lower layer having a thickness of 10 nm and a Pt upper layer having a thickness of 10 nm. Thereafter, the photoresist mask 12 is removed, whereby the Mg film 13 and the metal film 14 remain only on a portion of the n⁻-GaN layer 11 where a p-type region is formed (FIG. 1C).

Subsequently, thermal treatment is performed in an ammonia atmosphere at 900°C for three hours. Through this thermal treatment, Mg constituting the Mg film 13 is diffused in the n⁻-GaN layer 11 while being activated. Therefore, a p-type region 15 is formed in the n⁻-GaN layer 11 under the Mg film 13 (FIG. 1D). Thereafter, the Mg film 13 and the metal film 14 are removed by use of aqua regia (FIG. 1E), followed by thermal treatment in a nitrogen atmosphere at 850°C for five minutes. This thermal treatment step is performed in a nitrogen atmosphere for further activation of Mg, and this step may optionally be omitted.

When an electrode of the p-type region 15 is formed, a new metal layer may be formed on the p-type region 15 after the thermal treatment step in the nitrogen atmosphere.

And also when the metal film 14 is used for an electrode of the p-type region 15, the Mg film 13 and the metal film 14 may not be removed.

Through the above-described steps, p-type GaN (i.e., the p-type region 15) can be formed in a predetermined region. The metal film 14 is provided, since the melting point of Mg (i.e., 651°C) is lower than the thermal treatment temperature (i.e., 900°C). Provision of the metal film 14, which exhibits the effect of suppressing vaporization of Mg, enables the p-type regions 15 to be formed at high reliability and reproducibility.

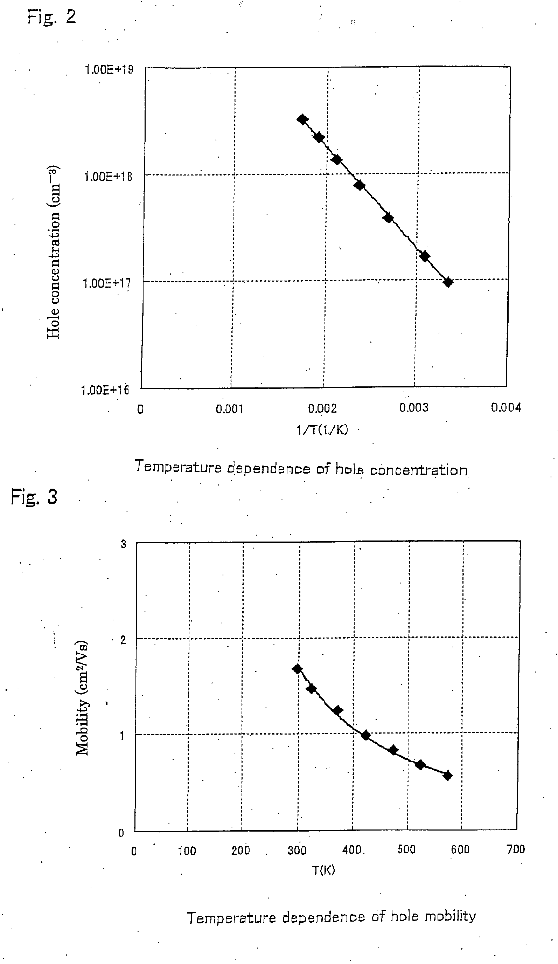

FIG. 2 is a graph showing temperature dependence of hole concentration of the p-type region 15 formed through the steps according to Embodiment 1. The p-type region 15 has a hole concentration of 1 × 10¹⁷ cm⁻³ at ambient temperature (300 K). FIG. 3 is a graph showing temperature dependence of hole mobility of the p-type region 15. Hole concentration and hole mobility were calculated at an Mg diffusion depth of 0.5 µm. Comparison of these data with the hole concentration and hole mobility of p-GaN formed through epitaxial growth with Mg doping shows that the p-type region 15 and the p-GaN have almost equivalent hole concentration and hole mobility.

Thus, the p-type region 15 can be selectively produced at high reliability and reproducibility.

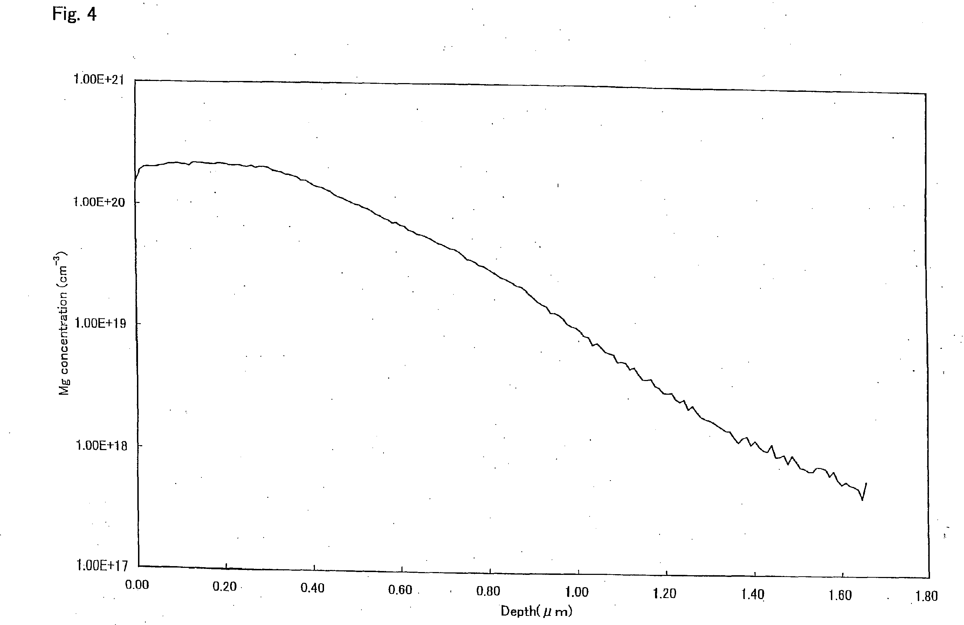

The relation between depth and Mg concentration of the p-type region 15 was investigated. The results are shown in the graph of FIG. 4. The horizontal axis corresponds to depth as measured from the surface of the n⁻-GaN layer 11 in a thickness direction. Within a depth range of 0 to 0.65 µm, the Mg concentration of the p-type region 15 is 5 × 10¹⁹ cm⁻³ or more, which is equal to or higher than the Mg concentration, within the corresponding depth range, of p-GaN formed through epitaxial growth with Mg doping.

### Embodiment 2

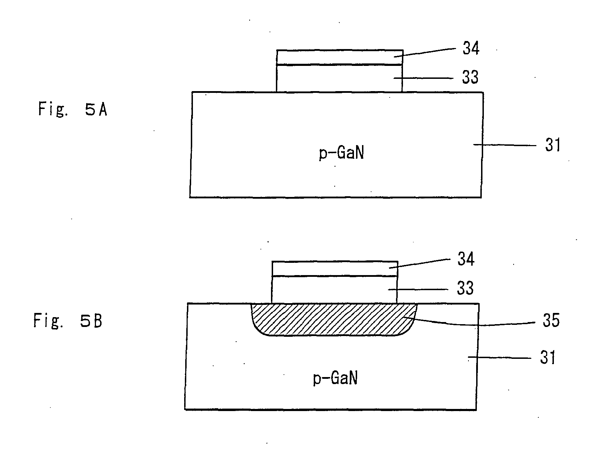

FIGs.5A and 5B show steps of a production method for an electrode according to Embodiment 2. The electrode is attached to p-GaN. The production steps according to Embodiment 2 will next be described with reference to FIGS. 5A and 5B.

Firstly, an Mg film 33 is formed on a p-GaN layer 31 in a region where an electrode is formed, and an Ni film 34 (corresponding to an electrode film employed in the present invention) is formed on the Mg film 33 (FIG. 5A) through the lift-off process in a manner similar to that of Embodiment 1. Subsequently, thermal treatment is performed in an ammonia atmosphere at 900°C for three hours. Through this thermal treatment, Mg constituting the Mg film 33 is diffused in the p-GaN layer 31 while being activated, whereby a p⁺-type region 35 having a hole concentration higher than that of the p-GaN layer 31 is formed (FIG. 5B).

The thus-formed electrode exhibits low contact resistance, since the p'-type region 35 serves as a contact region. Alternatively, an electrode may be formed through a method in which the Mg film 33 and the Ni film 34 are removed after thermal treatment employing ammonia, followed by formation of an Ni film on the p⁺-type region 35. This alternative method requires an increased number of steps as compared with the method according to Embodiment 2, but the thus-formed electrode exhibits contact resistance lower than that of the electrode formed through the method according to Embodiment 2.

The electrode may be formed on the n-type or intrinsic group III nitride semiconductor. In this case the p⁺-type region 35 is formed in the n-type or intrinsic group III nitride semiconductor, and the electrode functions as the electrode for the p⁺-type region 35.

In Embodiment 1, the metal film 14 is made of Ni/Pt. However, the metal film 14 may be made of, for example, Au. The n⁻-GaN layer 11 may be replaced by an i-GaN layer or a p-GaN layer. When a p-GaN layer is employed, a p-type region having a hole concentration higher than that of the p-GaN layer can be formed. In Embodiments 1 and 2, GaN is employed. However, a group III nitride semiconductor employed is not limited to GaN, and may be, for example, AIN, InN, AlGaN, InGaN, or AlGaInN.

According to the present invention, a p-type group III nitride semiconductor is selectively produced at excellent reliability and reproducibility. Therefore, the present invention can easily realize vertical semiconductor devices employing a group III nitride semiconductor; e.g., a pn diode, JFET, and HFET.

## Claims

1. A method for producing a p-type group III nitride semiconductor, said method comprising thermally diffusing Mg in a group III nitride semiconductor layer in an atmosphere containing at least ammonia, to thereby activate Mg and to form a p-type group III nitride semiconductor layer.

2. A method for producing a p-type group III nitride semiconductor, said method comprising:
forming an Mg film in a predetermined region on a surface of a group III nitride semiconductor layer;
forming, on said Mg film, a film of a metal having a melting point higher than the temperature of a thermal treatment which follows; and
performing said thermal treatment in an atmosphere containing at least ammonia.

3. A method for producing a p-type group III nitride semiconductor, said method further comprising:
after said performing said thermal treatment,
removing said Mg film and said metal film.

4. A method for producing a p-type group III nitride semiconductor as described in claim 1, wherein said group III nitride semiconductor layer is formed of an intrinsic or n-type group III nitride semiconductor.

5. A method for producing a p-type group III nitride semiconductor as described in claim 2, wherein said group III nitride semiconductor layer is formed of an intrinsic or n-type group III nitride semiconductor.

6. A method for producing a p-type group III nitride semiconductor as described in claim 3, wherein said group III nitride semiconductor layer is formed of an intrinsic or n-type group III nitride semiconductor.

7. A method for producing a p-type group III nitride semiconductor as described in claim 3, which further includes, after removal of said Mg film and said metal film, performing a thermal treatment in an atmosphere predominantly containing nitrogen.

8. A method for producing a p-type group III nitride semiconductor as described in claim 6, which further includes, after removal of said Mg film and said metal film, performing a thermal treatment in an atmosphere predominantly containing nitrogen.

9. A method for producing a p-type group III nitride semiconductor as described in claim 2, wherein formation of said Mg film and of said metal film on said Mg film is performed through a lift-off process.

10. A method for producing a p-type group III nitride semiconductor as described in claim 3, wherein formation of said Mg film and of said metal film on said Mg film is performed through a lift-off process.

11. A method for producing an electrode for a p-type group III nitride semiconductor, said method comprising
forming an Mg film in a predetermined region on a surface of a group III nitride semiconductor layer;
forming an electrode film on said Mg film; and
performing a thermal treatment in an atmosphere containing at least ammonia.

12. A method for producing an electrode for a p-type group III nitride semiconductor as described in claim 11,
which further includes, after said thermal treatment, performing an additional thermal treatment in an atmosphere predominantly containing nitrogen.

13. A method for producing an electrode for a p-type group III nitride semiconductor as described in claim 11,
which further includes, after said thermal treatment, removing said Mg film and said electrode film and forming a second electrode film on an exposed surface of said p-type group III nitride semiconductor layer.

14. A method for producing an electrode for a p-type group III nitride semiconductor as described in claim 11,
which further includes, after said thermal treatment, removing said Mg film and said electrode film, performing an additional thermal treatment in an atmosphere predominantly containing nitrogen thereafter and forming a second electrode film on an exposed surface of said p-type group III nitride semiconductor layer.

15. A method for producing an electrode for a p-type group III nitride semiconductor as described in claim 11,
which further includes, after said thermal treatment, removing said Mg film and said electrode film, forming a second electrode film on an exposed surface of said p-type group III nitride semiconductor layer thereafter and performing an additional thermal treatment in an atmosphere predominantly containing nitrogen.
